# EUROPEAN PATENT APPLICATION

(11) **EP 4 354 590 A1**
(43) Date of publication of application: **17.04.2024**
(21) Application number: 22889091.9
(22) Date of filing: 14.10.2022
(51) Int. Cl.: H01M 10/48

(54) **BATTERY, ELECTRICAL DEVICE, DETECTION METHOD, AND DETECTION MODULE**

(30) Priority: 04.11.2021 CN 202111298271
(71) Applicant: Contemporary Amperex Technology Co., Limited, Ningde City, Fujian 352100 (CN)
(72) Inventor: WU, Guisen, Ningde City, Fujian 352100 (CN); TAN, Hongjuan, Ningde City, Fujian 352100 (CN); LI, Wei, Ningde City, Fujian 352100 (CN)
(74) Representative: Behr, Wolfgang
(86) International application number: PCT/CN2022/125521
(87) International publication number: WO 2023/078066

(57) **Abstract**

A battery cell, a battery, an electricity-consuming apparatus, a detecting method and a detecting module are provided by the present application. The battery cell includes a casing including a wall part and an accommodating cavity enclosed and formed by the wall part; an electrode assembly located in the accommodating cavity and connected with a first electrode terminal and a second electrode terminal; a third electrode arranged on the wall part; and a signal line including a first signal line connected with the third electrode and the first electrode terminal and a second signal line connected with the third electrode and the second electrode terminal. The third electrode is directly arranged on the wall part of the casing, so that the arrangement is simple and facilitates the first signal line and the second signal line to connect with the third electrode.

## Description

### CROSS REFERENCE TO RELATED APPLICATION

The present application claims priority to Chinese Patent Application No. 202111298271.6, titled "BATTERY, BATTERY, ELECTRICITY-CONSUMING APPARATUS, DETECTING METHOD, AND DETECTING MODULE" and filed on November 4, 2021, which is hereby incorporated by reference in its entirety.

### TECHNICAL FIELD

The present application relates to the technical field of batteries, and in particular to a battery cell, a battery, an electricity-consuming apparatus, a detecting method and a detecting module.

### BACKGROUND

Energy conservation and emission reduction are keys to the sustainable development of the automotive industry, and an electric vehicle has become an important component of the sustainable development of the automotive industry due to its advantages in energy conservation and environmental protection. Furthermore, the battery technology is an important factor related to the development of the electric vehicle.

In order to detect the performance of a battery, it is necessary to detect the electrical parameters of two electrode terminals on a battery cell in the battery, and for example, to detect the voltage parameters of the two electrode terminals. Therefore, how to detect the electrified condition of the electrode terminals of the battery cell has become an urgent problem to be solved.

### SUMMARY

In view of the above problems, the present application provides a battery cell, a battery, an electricity-consuming apparatus, a detecting method and a detecting module that can accurately detect the electrified condition of an electrode terminal in the battery cell.

In a first aspect, embodiments of the present application provide a battery cell including a casing including a wall part and an accommodating cavity enclosed and formed by the wall part; an electrode assembly located in the accommodating cavity and connected with a first electrode terminal and a second electrode terminal; a third electrode arranged on the wall part; and a signal line including a first signal line connected with the third electrode and the first electrode terminal and a second signal line connected with the third electrode and the second electrode terminal.

In the technical solution of the embodiments of the present application, the battery cell includes the casing, the electrode assembly located in the casing, the third electrode located on the casing and the signal line. The signal line includes the first signal line and the second signal line, the first signal line is used to connect the first electrode terminal and the third electrode of the electrode assembly to obtain the electrified condition of the first electrode terminal, and the second signal line is used to connect the second electrode terminal and the third electrode to obtain the electrified condition of the second electrode terminal. The third electrode is directly arranged on the wall part of the casing, so that the arrangement is simple and facilitates the first signal line and the second signal line to connect with the third electrode. The first signal line is used to collect a voltage difference signal between the first electrode terminal and the third electrode, and the second signal line is used to collect a voltage difference signal between the second electrode terminal and the third electrode.

In some embodiments, the casing includes a conductive material and is multiplexed as the third electrode, the first signal line is connected with the casing and the first electrode terminal, and the second signal line is connected with the casing and the second electrode terminal. By multiplexing the casing as the third electrode without the need for arranging an additional third electrode, the structure of the battery cell can be further simplified. In addition, the casing usually includes the conductive material that is not easily corroded, so that the third electrode is not easily corroded, and the detection result can be more accurate.

In some embodiments, the wall part includes a casing body with an opening and an end cover covering the opening, the end cover is multiplexed as the third electrode, the first signal line is connected with the end cover and the first electrode terminal, and the second signal line is connected with the end cover and the second electrode terminal. By multiplexing the end cover as the third electrode, the structure of the battery cell can be further simplified. A sampling part is usually arranged outside the end cover, and the first signal line and second signal line are further connected to the sampling part. The end cover is multiplexed as the third electrode, which not only facilitates the first signal line and the second signal line to connect to the third electrode, but also facilitates the first signal line and the second signal line connected to the sampling part.

In some embodiments, the wall part includes a casing body with an opening and an end cover covering the opening, and the third electrode is located on a side of the end cover away from the accommodating cavity, so that it can facilitate the first signal line and the second signal line to connect with the third electrode.

In a second aspect, the embodiments of the present application further provide a battery, including the battery cell according to any one of the above embodiments.

In a third aspect, the embodiments of the present application further provide an electricity-consuming apparatus, including the battery as described above. The battery is used to supply electric power.

In a fourth aspect, the embodiments of the present application further provide a detecting method, including
providing a battery cell, including an electrode assembly and a third electrode, in which the electrode assembly includes a first electrode terminal and a second electrode terminal, and the first electrode terminal is a negative electrode terminal;
obtaining a voltage difference between the first electrode terminal and the third electrode; and
determining a setting parameter of the battery cell according to the voltage difference.

In the technical solution of the embodiments of the present application, by using the third electrode as a reference electrode, the voltage difference between the first electrode terminal and the third electrode can be obtained, that is, the voltage difference between the negative electrode terminal and the third electrode can be obtained. According to the voltage difference, the setting parameter of the battery cell can be determined, and the performance of the battery cell can be determined.

In some embodiments, the battery cell further includes a casing, the electrode assembly is located in the casing, and the casing is multiplexed as the third electrode; in the step of obtaining the voltage difference between the first electrode terminal and the third electrode: obtaining a first voltage difference between the casing and the first electrode terminal that are not in a charging-and-discharging state within a predetermined time period; in the step of determining the setting parameter of the battery cell according to the voltage difference: determining that corrosion of the casing occurs when the first voltage difference decreases within the predetermined time period. By multiplexing the casing as the third electrode, the corrosion of the casing can be determined according to the voltage difference between the third electrode and the negative electrode terminal. When the first voltage difference decreases, it indicates that there is electric charge transfer between the negative electrode terminal and the casing that are not in the charging-and-discharging state, and corrosion of the casing occurs. The detecting method in the embodiments of the present application can not only indicate that the battery cell has fault, but also determine that the fault type is the corrosion of the casing, which can reduce the risk of the thermal runaway of the battery cell.

In some embodiments, in the step of determining the setting parameter of the battery cell according to the voltage difference: determining that the corrosion of the casing is severe and sending an alarm signal when the first voltage difference is less than or equal to a first voltage threshold within the predetermined time period. It can determine whether the corrosion of the casing is severe by comparing the first voltage difference and the first voltage threshold. When the corrosion of the casing is severe, the alarm signal is sent, so that it can facilitate the user to timely understand the condition of the corrosion of the casing and improve the safety performance of the battery cell.

In some embodiments, in the step of obtaining the voltage difference between the first electrode terminal and the third electrode: obtaining a second voltage difference between the first electrode terminal and the third electrode in a charging state; in the step of determining a setting parameter of the battery cell according to the voltage difference: determining that lithium precipitation of the first electrode terminal occurs when the second voltage difference is less than or equal to a second voltage threshold. By comparing the second voltage threshold with the second voltage difference in the charging state, it can be determined whether the lithium precipitation of the negative electrode terminal occurs. The detecting method in the embodiments of the present application can not only indicate that the battery cell has fault, but also determine that the fault type is lithium precipitation of the negative electrode terminal, which can reduce the risk of the thermal runaway of the battery cell.

In a fourth aspect, the embodiments of the present application further provide a detecting module for a battery cell. The battery cell includes an electrode assembly and a third electrode, the electrode assembly includes a first electrode terminal and a second electrode terminal, the first electrode terminal is a negative electrode terminal, and the detecting module includes an obtaining unit, configured to obtain a voltage difference between the first electrode terminal and the third electrode; and a processing unit, configured to determine a setting parameter of the battery cell according to the voltage difference.

In the technical solution in the embodiments of the present application, by using the third electrode as the reference electrode, the obtaining unit can obtain the voltage difference between the first electrode terminal and the third electrode, that is, the voltage difference between the negative electrode terminal and the third electrode. The processing unit can determine the setting parameter of the battery cell and determine the performance of the battery cell according to the voltage difference.

In some embodiments, the battery cell further includes a casing, the electrode assembly is located in the casing, and the casing is multiplexed as the third electrode; the obtaining unit is configured to obtain a first voltage difference between the first electrode terminal and the casing of the battery cell that are not in a charging-and-discharging state within a predetermined time period; and the processing unit is configured to determine that corrosion of the casing occurs when the first voltage difference decreases within the predetermined time period. By multiplexing the casing as the third electrode, the processing unit can determine the corrosion of the casing based on the voltage difference between the third electrode and the negative electrode terminal. When the first voltage difference decreases, it indicates that there is electric charge transfer between the negative electrode terminal and the casing that are not in the charging-and-discharging state, and corrosion of the casing occurs. The detecting module in the embodiments of the present application can not only indicate that the battery cell has fault, but also determine that the fault type is the corrosion of the casing, which can reduce the risk of the thermal runaway of the battery cell.

In some embodiments, the processing unit is further configured to determine that the corrosion of the casing is severe and send an alarm signal when the first voltage difference is less than or equal to a first voltage threshold. The processing unit can determine whether the corrosion of the casing is severe by comparing the first voltage difference and the first voltage threshold. When the corrosion of the casing is severe, the alarm signal is sent, so that it can facilitate the user to timely understand the condition of the corrosion of the casing and improve the safety performance of the battery cell.

In some embodiments, the obtaining unit is further configured to obtain a second voltage difference between the first electrode terminal and the third electrode of the battery cell in a charging state, and the processing unit is further configured to determine that lithium precipitation of the first electrode terminal occurs when the second voltage difference is less than or equal to a second voltage threshold. The processing unit can determine whether lithium precipitation of the negative electrode terminal occurs by comparing the second voltage threshold with the second voltage difference in the charging state. The detecting module in the embodiments of the present application can not only indicate that the battery cell has fault, but also determine that the fault type is lithium precipitation of the negative electrode terminal, which can reduce the risk of the thermal runaway of the battery cell.

In the embodiments of the present application, by arranging the third electrode in the casing of the battery instead of the electrode assembly, the arrangement of the third electrode can be simplified, and the structure of the battery cell can be simplified. The electrified condition of the first electrode terminal can be obtained by connecting the first signal line with the third electrode and the first electrode terminal, and the electrified condition of the second electrode terminal can be obtained by connecting the second signal line with the third electrode and the second electrode terminal, so as to accurately determine whether the battery cell has fault.

The above description is only an overview of the technical solution of the present application. In order to more clearly understand of the technical solution of the present application, it can be implemented according to the content of the description. In order to make the above and other objects, features and advantages of the present application more obvious and understandable, the specific embodiments of the present application are hereby listed.

### BRIEF DESCRIPTION OF THE DRAWINGS

By reading the detailed description of the preferred embodiments below, various other advantages and benefits will become clear to those skilled in the art. The drawings are only intended to illustrate the preferred embodiments and are not considered a limitation of the present application. In addition, throughout the whole drawings, the same reference numerals are used to represent the same parts. In the drawings:
Fig. 1 shows a structural schematic view of a vehicle according to an embodiment of the present application;
Fig. 2 shows a structural schematic view of a battery pack according to an embodiment of the present application;
Fig. 3 shows a structural schematic view of a battery module according to an embodiment of the present application;
Fig. 4 shows an exploded structural schematic view of a battery cell according to an embodiment of the present application;
Fig. 5 shows an exploded structural schematic view of a battery cell according to another embodiment of the present application;
Fig. 6 shows a flowchart of a detecting method for a battery cell according to an embodiment of the present application;
Fig. 7 shows a curve line chart of a voltage difference of a battery cell that is not in a charging-and-discharging state according to an embodiment of the present application;
Fig. 8 shows a curve line chart view of a voltage difference of a battery cell in a charging state according to an embodiment of the present application;
Fig. 9 shows a structural schematic view of a detecting module of a battery cell according to an embodiment of the present application;
Fig. 10 shows a flowchart of a detecting method for a battery cell according to another embodiment of the present application; and
Fig. 11 shows a flowchart of a detecting method for a battery cell according to another embodiment of the present application.

The reference numerals in the specific embodiments are as follows:
1-vehicle; 10-battery; 11-controller; 12-motor;
20-battery module; 21-battery cell; 21a-casing; 21aa-wall part; 211-end cover; 211a-first electrode terminal; 211b-second electrode terminal; 212-casing body; 213-electrode assembly; 214-accommodating cavity; 215-third electrode; 216-signal line; 216a-first signal line; 216b-second signal line;
30-housing; 301-first housing portion; 302-second housing portion;
40-detecting module; 401-obtaining unit; 402-processing unit.

### DETAILED DESCRIPTION

Embodiments of the technical solution of the present application will be described in further detail below in conjunction with the drawings. The following embodiments are only used to illustrate the technical solutions of the present application more clearly, and are therefore only used as examples, and cannot be used to limit the protection scope of the present application.

It should be noted that, unless otherwise defined, the technical terms or scientific terms used in the embodiments of the present application shall have the usual meanings understood by those skilled in the art to which the embodiments of the present application belong.

In the description of the present application, the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential" and the like indicating the orientation or positional relationship are based on the orientation or positional relationship shown in the drawings, and are only for the convenience of describing the embodiments of the present application and simplifying the description, rather than indicating or implying that the referred device or element must have a specific direction or position or be constructed and operate in a specific direction or position. Therefore, it cannot be construed as a limitation on the embodiments of the present application.

In addition, the technical terms "first", "second" and the like are only used for descriptive purposes and cannot be understood as indicating or implying the relative importance or implying the quantity of indicated technical features. In the description of the embodiments of the present application, the meaning of "plurality" refers to two or more, unless otherwise specified.

In the description of the present application, unless otherwise clearly specified and limited, the terms "mount", "communicate", "connect" and "fix" should be understood in a broad sense, for example, it can be a fixed connection, a detachable connection, or an integral connection, it can be a mechanical connection or an electrical connection; it can be a direct connection, or it can be connected indirectly through an intermediary, it can be a communication within the two elements or an interaction relationship between the two elements. For those of ordinary skill in the art, the specific meaning of the above-mentioned terms in the present application can be understood according to specific situations.

In the description of the embodiments of the present application, unless otherwise specified and limited, the expression that the first feature is "above" or "below" the second feature may mean that the first feature is in directly contact with the second feature, or the first feature is in indirectly contact with the second feature through intermediate media. Moreover, the expression that the first feature is "above", "over" or "on" the second feature may mean that the first feature is directly or diagonally above the second feature, or merely indicates that the horizontal height of the first feature is higher than that of the second feature. The expression that the first feature is "below", "under" or "underneath" the second feature may mean that the first feature is directly or diagonally below the second feature, or merely indicates that the horizontal height of the first feature is lower than that of the second feature.

At present, based on the development of the market situation, the application of a power battery is becoming increasingly widespread. The power battery is not only used in energy storage power systems such as hydropower, firepower, wind power and solar power plants, but also widely used in electric means of transportation such as an electric bicycle, an electric motorcycle and an electric vehicle, as well as in various fields such as military equipment and aerospace. With the continuous expansion of the application field of the power battery, the market demand of the power battery is also constantly expanding.

In the present application, a battery cell may include a lithium-ion battery, a lithium-sulfur battery cell, a sodium lithium-ion battery cell, a magnesium-ion battery cell and the like, which is not limited in the embodiments of the present application. The battery cell can be in a shape of a cylinder, a flatten body, a cuboid or other shapes, which is not limited in the embodiments of the present application.

The battery mentioned in the embodiments of the present application refers to a single physical module that includes one or more battery cells to provide higher voltage and capacity. For example, the battery mentioned in the present application may include a battery module, a battery pack or the like. The battery generally includes a housing for packaging one or more battery cells. The housing can prevent liquid or other foreign objects from affecting the electrical charge or the electrical discharge of the battery cell.

The battery cell includes an electrode assembly and an electrolyte, and the electrode assembly includes a positive electrode sheet, a negative electrode sheet and a separator. The battery cell mainly relies on the movement of metal ions between the positive electrode sheet and the negative electrode sheet to work. The positive electrode sheet includes a positive electrode current collector and a positive electrode active material layer applied on the surface of the positive electrode current collector. The positive electrode current collector includes a positive electrode current collecting portion and a positive electrode tab connected to the positive electrode current collecting portion. The positive electrode current collecting portion is coated with the positive electrode active material layer, and the positive electrode tab is not coated with the positive electrode active material layer. Taking a lithium ion battery as an example, the material of the positive electrode current collector may be aluminum, and the positive electrode active material layer includes a positive electrode active material, which may be lithium cobaltate, lithium iron phosphate, ternary lithium, lithium manganite or the like. The negative electrode sheet includes a negative electrode current collector and a negative electrode active material layer applied on the surface of the negative electrode current collector. The negative electrode current collector includes a negative electrode current collecting portion and a negative electrode tab. The negative electrode current collecting portion is coated with the negative electrode active material layer, and the negative electrode tab is not coated with the negative electrode active material layer. The material of the negative electrode current collector may be copper, and the negative electrode active material layer includes a negative electrode active material, which may be carbon, silicon or the like. The material of the separator may be PP (polypropylene), PE (polyethylene) or the like.

In order to ensure the safety performance of the battery cell, it is necessary to monitor the voltage changes of the electrode terminals of the battery cell. The inventors notice that in the related art, in order to detect the voltage situation of two electrode terminals in the battery cell, a reference electrode is arranged, and the voltage changes of the electrode terminals can be determined by comparing the voltage difference between the reference electrode and the two electrode terminals. In the related art, the reference electrode is usually arranged between two electrode plates. For example, the reference electrode is copper wire coated with lithium metal, and the reference electrode is implanted into the stacked electrode assembly. The operation of inserting the reference electrode into the electrode assembly itself is relatively complex, and considering the problem of easy oxidation of lithium metal, it is also necessary to insert the reference electrode into the electrode assembly in a closed environment, which leads to complex and difficult manufacturing of the battery cell.

In order to solve the problem of the complex structure of the battery cell, the applicant has found that the reference electrode can be arranged on the casing body of the battery cell, for example, the casing body of the battery cell can be multiplexed as the reference electrode.

Based on the above considerations, in order to solve the problem of the complex structure of the battery cell and obtain the voltage of the two electrode terminals in the battery cell, the inventors have conducted in-depth research and designed a battery cell. In such battery cell, the third electrode is arranged on the casing body of the battery cell, so that it can simplify the structure of the battery cell and obtain the voltage of the two electrode terminals in the battery cell according to the voltage difference between the third electrode and the two electrode terminals.

The technical solution described in the embodiments of the present application is applicable to a battery and an electricity-consuming apparatus using the battery.

The electricity-consuming apparatus may be a vehicle, a mobile phone, a portable device, a notebook computer, a ship, a spacecraft, an electric toy, an electric tool or the like. The vehicle may be a fuel car, a gas car or a new energy car, and the new energy car can be a pure electric car, a hybrid car, a range-extended car or the like; the spacecraft may include an airplane, a rocket, a space shuttle, a space ship or the like; the electric toy may include a fixed-type or mobile-type electric toy, such as a game player, an electric car toy, an electric ship toy, an electric airplane toy or the like; the power tool may include a metal cutting power tool, a grinding power tool, an assembly power tool and a railway power tools, such as an electric drill, an electric grinder, an electric wrench, an electric screwdriver, an electric hammer, an impact drill, a concrete vibrator, an electric planers or the like. Embodiments of the present application do not impose specific limitation to the above-mentioned electricity-consuming apparatus.

It should be understood that the technical solution described in the embodiments of the present application is not only applicable to the battery and the electricity-consuming apparatus described above, but can also be applicable to all batteries including housings and all electricity-consuming apparatus using the batteries. However, for the sake of simplicity, all the following embodiments are illustrated by taking an electric vehicle as examples.

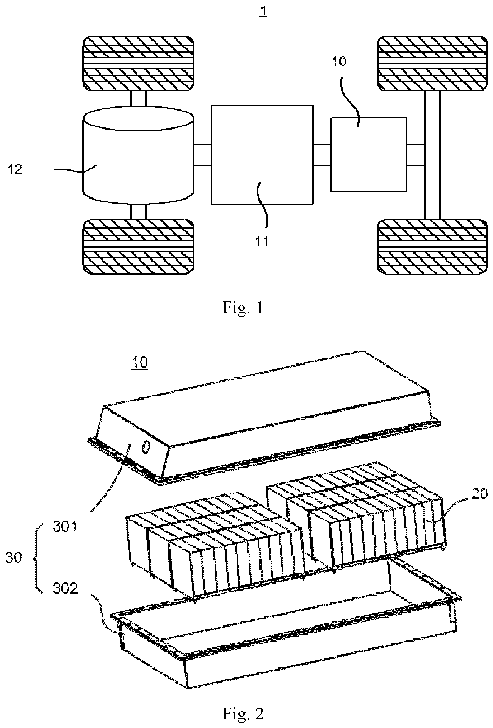

Referring to Fig. 1, Fig. 1 shows a structural schematic view of a vehicle 1 according to some embodiments of the present application. The vehicle 1 can be may be a fuel car, a gas car or a new energy car, and the new energy car can be a pure electric car, a hybrid car, a range-extended car or the like. A battery 10 may be arranged inside the vehicle 1, and the battery 10 may be arranged in the bottom, the front or the back of the vehicle 1. The battery 10 can be used to supply power to the vehicle 1, for example, the battery 10 can be used as an operating power source of the vehicle 1. The vehicle 1 may further include a controller 11 and a motor 12, the controller 11 can be used to control the battery 10 to supply power to the motor 12, for example, for satisfying the work electricity needs of the vehicle 1 during starting, navigating and driving.

In some embodiments of the present application, the battery 10 can not only serve as an operating power source for the vehicle 1, but also as a driving power source for the vehicle 1, so as to replace or partially replace the fuel or the natural gas and provide the driving power for the vehicle 1.

In order to meet different electricity power needs, the battery 10 may include a plurality of battery cells, which refer to the smallest unit that constitutes a battery module or battery pack. The plurality of battery cells 21 can be connected in series and/or in parallel through electrode terminals for applying to various applications. The battery mentioned in the present application includes the battery module or the battery pack. Among them, the plurality of battery cells can be connected in series, parallel or hybrid, and the hybrid connection refers to the combination of the series connection and the parallel connection. The battery 10 can also be referred to as the battery pack. In the embodiments of the present application, the plurality of battery cells can directly form the battery pack, or can form the battery modules firstly, and then the battery modules forms the battery pack.

Fig. 2 shows a structural schematic view of a battery 10 according to an embodiment of the present application.

As shown in Fig. 2, the battery includes a housing 30 and the battery cell (not shown in the figure), and the battery cell is accommodated in the housing 30.

The housing 30 can be a simple three-dimensional structure such as a separate cuboid, cylinder or sphere, or can be a complex three-dimensional structure composed of a combination of simple three-dimensional structures such as a cuboid, cylinder or sphere, which is not limited in the embodiments of the present application. The material of the housing 30 can be an alloy material such as aluminum alloy and iron alloy, or can be a polymer material such as polycarbonate and polyisocyanurate foam plastic, or can be a composite material such as glass fiber and epoxy resin, which is not limited in the embodiments of the present application.

The housing 30 can be used to accommodate the battery cell and can be of various structures. In some embodiments, the housing 30 may include a first housing portion 301 and a second housing portion 302, and the first housing portion 301 and the second housing portion 302 cover each other. The first housing portion 301 and the second housing portion 302 jointly define an accommodating space for accommodating the battery cell. The second housing portion 302 may be a hollow structure with an opening at an end, the first housing portion 301 may be a plate-like structure, and the first housing portion 301 can cover on an opening side of the second housing portion 302 to form the housing 30 with accommodating space. Alternatively, each of the first housing portion 301 and the second housing portion 302 can be a hollow structure with an opening on a side. An opening side of the first housing portion 301 may cover an opening side of the second housing portion 302 to form the housing 30 with accommodating space. Of course, the first housing portion 301 and the second housing portion 302 can be of various shapes, such as a cylinder and a cuboid.

In order to improve the sealing performance of the first housing portion 301 and the second housing portion 302 after connected with each other, a sealing member such as a sealant or a sealing rings, can be arranged between the first housing portion 301 and the second housing portion 302.

Assuming that the first housing portion 301 covers a top of the second housing portion 302, the first housing portion 301 can be referred to as an upper housing cover, and the second housing portion 302 can be referred to as an casing body.

In the battery 10, there may be one or more battery cells. If there are a plurality of battery cells, the plurality of battery cells can be connected in series, in parallel or in hybrid. The hybrid connection means that the plurality of battery cells are connected in series and parallel in combination. The plurality of battery cells can be directly connected in series, parallel or hybrid together, and then a whole composed of the plurality of battery cells can be accommodated in the housing 30. Of course, alternatively, the plurality of battery cells can be connected in series, in parallel or hybrid to form the battery module 20. A plurality of battery modules 20 are connected in series, in parallel or in hybrid to form a whole and are accommodated in the housing 30.

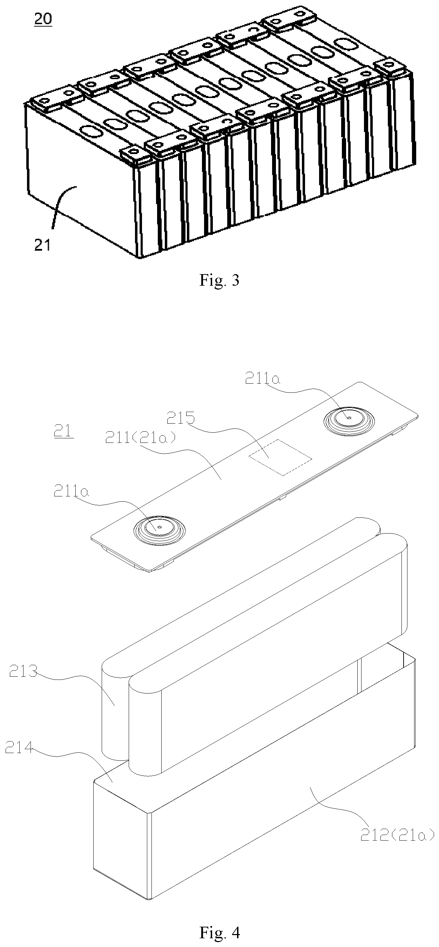

Fig. 3 shows a structural schematic view of a battery module 20 according to an embodiment of the present application.

In some embodiments, as shown in Fig. 3, the battery module 20 has a plurality of battery cells 21. The plurality of battery cells 21 are connected in series, in parallel or in hybrid firstly to form the battery module 20. The plurality of battery modules 20 are connected in series, in parallel or in hybrid to form a whole and are accommodated in the housing 30.

The plurality of battery cells 21 in the battery module 20 can be electrically connected through a bus bar to achieve the parallel, series or hybrid connection of the plurality of battery cells 21 in the battery module 20.

In the present application, the battery cell 21 may include a lithium-ion battery cells 21, a sodium-ion battery, or a magnesium-ion battery or the like, which is not limited in the embodiments of the present application. The battery cell 21 can be in a shape of a cylinder, a flatten body, a cuboid or other shapes, which is not limited in the embodiments of the present application. Generally, the battery cell 21 can be divided into three types in packaging: a cylindrical battery cell 21, a cuboid rectangle battery cell 21 and soft pack battery cell 21, which is not limited in the embodiments of the present application. However, for the sake of brevity, the following embodiments are all illustrated by taking the cuboid rectangle battery cell 21 as an example.

Fig. 4 shows an exploded structural schematic view of the battery cell 21 according to some embodiments of the present application. The battery cell 21 refers to the smallest unit that constitutes the battery. As shown in Fig. 4, the battery cell 21 includes an end cover 211, a casing body 212 and an electrode assembly 213.

The end cover 211 refers to a part that covers an opening of the casing body 212 to isolate the internal environment of the battery cell 21 from the external environment. Unlimitedly, a shape of the end cover 211 can adapt to a shape of the casing body 212 to fit the casing body 212. Optionally, the end cover 211 can be made of a material with a certain hardness and strength (such as aluminum alloy), so that the end cover 211 is less prone to deformation when subjected to compression and collision, the battery cell 21 can have higher structural strength, and the safety performance can be improved. A functional part, such as a first electrode terminal 211a and a second electrode terminal 211b, can be arranged on the end cover 211. The first electrode terminal 211a and the second electrode terminal 211b can be electrically connected to the electrode assembly 213 to output or input the electrical energy of the battery cell 21. In some embodiments, the end cover 211 may also be provided with a pressure-relief mechanism for releasing the internal pressure when the internal pressure or temperature of the battery cell 21 reaches a threshold. The material of the end cover 211 can also be various, such as copper, iron, aluminum, stainless steel, aluminum alloy or plastic, which is not specially limited in the embodiments of the present application. In some embodiments, an insulating member can be arranged on an inner side of the end cover 211, which can be used to isolate an electrical connecting part inside the casing body 212 from the end cover 211 to reduce the risk of the short circuit. Exemplarily, the insulating member may be made by plastic, rubber or the like.

The casing body 212 is an assembly that is used to fit the end cover 211 to form an internal environment of the battery cell 21, and the formed internal environment can be used to accommodate the electrode assembly 213, electrolyte solution (not shown in the figure) and other parts. The casing body 212 and the end cover 211 can be separate parts, and an opening can be formed on the casing body 212. The end cover 211 can cover the opening at the opening to form the internal environment of the battery cell 21. Unlimitedly, it is also possible to integrate the end cover 211 and the casing body 212. Specifically, the end cover 211 and the casing body 212 can form a common connection face before other parts enter into the casing. When it is necessary to encapsulate an interior of the casing body 212, the end cover 211 can then cover the casing body 212. The casing body 212 can be of various shapes and sizes, such as a cuboid, a cylinder or a hexagonal prism. Specifically, the shape of the casing body 212 can be determined based on the specific shape and size of the electrode assembly 213. The casing body 212 can be made of various materials, such as copper, iron, aluminum, stainless steel, aluminum alloy or plastic, which is not specially limited in the embodiments of the present application.

The electrode assembly 213 is a part that occurs the electrochemical reaction in the battery cell 21. One or more electrode assembly 213 can be included in the casing body 212. The electrode assembly 213 is mainly formed by winding or stacking a positive electrode plate and a negative electrode plate, and usually has a separator between the positive electrode plate and the negative electrode plate. Portions of the positive electrode plate and the negative electrode plate with the active substance form a main body of the electrode assembly, while other portions of the positive electrode plate and the negative electrode plate without the active substance form the electrode tabs respectively (not shown in the figure). A positive electrode tab and a negative electrode tab can be located at one end of the main body together or at two ends of the main body respectively. During the charging-and-discharging process of the battery, the positive active substance and the negative active substance react with the electrolyte solution, and the electrode tabs are connected to the electrode terminals to form a current circuit.

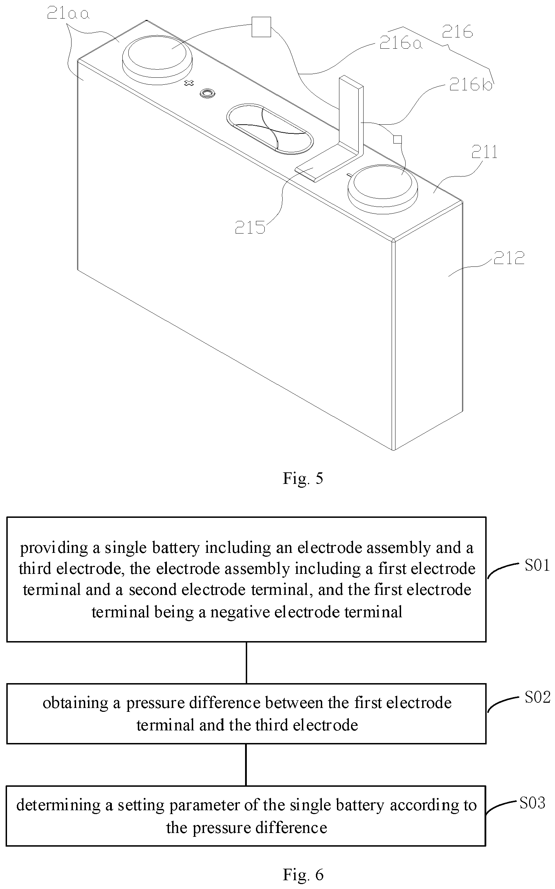

Referring to Fig. 4 and Fig. 5, Fig. 5 shows a structural schematic view of the battery cell 21 according to another embodiment of the present application.

As shown in Fig. 4 and Fig. 5, some embodiments of the present application provide the battery cell 21 including: a casing 21a, including a wall part 21aa and an accommodating cavity 214 enclosed and formed by the wall part 21aa; an electrode assembly 213, located in the accommodating cavity 214 and connected with a first electrode terminal 211a and a second electrode terminal 211b; a third electrode 215, arranged on the wall part 21aa; and a signal line 216, including a first signal line 216a connected with the third electrode 215 and the first electrode terminal 211a, and a second signal line 216b connected with the third electrode 215 and the second electrode terminal 211b.

The electrode assembly 213 includes the positive electrode plate and the negative electrode plate. The positive electrode plate is provided with the positive electrode tab, and the negative electrode plate is provided with the negative electrode tab. The first electrode terminal 211a is connected to one of the positive electrode tab and the negative electrode tab, and the second electrode terminal 211b is connected to the other of the positive electrode tab and the negative electrode tab. For example, the first electrode terminal 211a is connected to the negative electrode tab to be as a negative electrode terminal, and the second electrode terminal 211b is connected to the positive electrode tab to be as a positive electrode terminal.

The third electrode 215 is a reference electrode, and the first signal line 216a is connected to the third electrode 215 and the first electrode terminal 211a. The first signal line 216a is used to obtain a voltage difference signal between the first electrode terminal 211a and the third electrode 215. The second signal line 216b is connected to the third electrode 215 and the second electrode terminal 211b. The second signal line 216b is used to obtain a voltage difference signal between the third electrode 215 and the second electrode terminal 211b. The first electrode terminal 211a, the second electrode terminal 211b and the casing body 212 are insulated from one another, and the first electrode terminal 211a, the second electrode terminal 211b and the third electrode 215 are insulated from one another.

The first signal line 216a can be a complete line, or the first signal line 216a can include two sub signal lines. For example, a voltage detecting device is arranged between the two sub signal lines; one end of the voltage detecting device is connected to the first electrode terminal 211a through one of the sub signal lines, and the other end of the voltage detecting device is connected to the third electrode 215 through the other of sub signal lines, so that the voltage detecting device can obtain the voltage difference between the first electrode terminal 211a and the third electrode 215 through the two sub signal lines of the first signal line 216a. The arrangement of the second signal line 216b is similar to that of the first signal line 216a and will not be repeated.

In the technical solution of the embodiments of the present application, the battery cell includes the casing 21a, the electrode assembly 213 located in the casing 21a, the signal line 216 and the third electrode 215 located on the casing 21a. The signal line 216 includes the first signal line 216a and the second signal line 216b. The first signal line 216a is used to connect the first electrode terminal 211a and the third electrode 215 of the electrode assembly 213 to obtain the electrified condition of the first electrode terminal 211a. The second signal line 216b is used to connect the second electrode terminal 211b and the third electrode 215 to obtain the electrified condition of the second electrode terminal 211b. The third electrode 215 is directly arranged on the wall part 21aa of the casing 21a, and the arrangement is simple, so that it facilitates connecting the first signal line 216a and the second signal line 216b with the third electrode 215.

According to some embodiments of the present application, as shown in Fig. 4, the casing 21a includes the conductive material and is multiplexed as the third electrode 215. The first signal line 216a is connected with the casing 21a and the first electrode terminal 211a, and the second signal line 216b is connected with the casing 21a and the second electrode terminal 211b.

As mentioned above, the casing body 212 includes the material such as aluminum alloy, so that the casing body 212 can conduct electricity. When the first signal is connected with the casing 21a and the first electrode terminal 211a, the voltage difference between the casing body 212 and the first electrode terminal 211a can be obtained through the first signal line 216a. When the second signal line 216b is connected with the casing 21a and the second electrode terminal 211b, the voltage difference between the casing body 212 and the second electrode terminal 211b can be obtained through the second signal line 216b.

In these embodiments, by multiplexing the casing 21a as the third electrode 215 without the need for arranging an additional third electrode 215, the structure of the battery cell 21 can be further simplified. In addition, the casing 21a usually includes the conductive material that is not easily corroded, so that the third electrode 215 is not easily corroded, and the detection result can be more accurate.

According to some embodiments of the present application, as shown in Fig. 4, the wall part 21aa includes the casing body 212 with an opening and an end cover 211 covering the opening. That is, the casing 21a includes the casing body 212 and the end cover 211. The end cover 211 is multiplexed as the third electrode 215, the first signal line 216a connects the end cover 211 with the first electrode terminal 211a, and the second signal line 216b connects the end cover 211 with the second electrode terminal 211b. A dashed line in Fig. 4 illustrates the position of the third electrode 215 on the end cover 211, which is not sufficient to limit the structure of the present application embodiments.

The end cover 211 includes the conductive material, such as aluminum alloy, aluminum metal and other conductive materials. When the first signal connects the end cover 211 with the first electrode terminal 211a, the voltage difference between the end cover 211 and the first electrode terminal 211a can be obtained through the first signal line 216a. When the second signal line 216b connects the end cover 211 with the second electrode terminal 211b, the voltage difference between the end cover 211 and the second electrode terminal 211b can be obtained through the second signal line 216b.

In these embodiments, by multiplexing the end cover 211 as the third electrode 215, the structure of the battery cell can be further simplified. A sampling part is usually located outside the end cover 211, and the first signal line 216a and second signal line 216b are also connected to the sampling part. The end cover 211 is multiplexed as the third electrode 215, which not only facilitates connecting the first signal line 216a and the second signal line 216b with the third electrode 215, but also facilitates connecting the first signal line 216a and the second signal line 216b with the sampling part.

According to some embodiments of the present application, as shown in Fig. 5, the third electrode 215 is arranged on a side of the end cover 211 away from the accommodating cavity 214. For example, the third electrode 215 is welded to the side of the end cover 211 away from the accommodating cavity 214, so that it facilitates connecting the third electrode 215 with the first signal line 216a and the second signal line 216b.

According to some embodiments of the present application, the present application further provides a battery, including the battery cell as described in any one of the above solutions.

According to some embodiments of the present application, the present application further provides an electricity-consuming apparatus, including the battery as described in any one of the above solutions, and the battery is used to supply electric power to the electricity-consuming apparatus.

The electricity-consuming apparatus can be any one of the aforementioned devices or systems applying the battery.

Referring to Fig. 6, Fig. 6 shows a flowchart of a detecting method for the battery cell according to an embodiment of the present application. The battery cell can be the battery cell shown in Fig. 4 and Fig. 5.

According to some embodiments of the present application, referring to Fig. 4 to Fig. 6 together, the detecting method provided by the present application includes:

Step S01: providing a battery cell 21, including an electrode assembly 213 and a third electrode 215, in which the electrode assembly 213 includes a first electrode terminal 211a and a second electrode terminal 211b, and the first electrode terminal 211a is a negative electrode terminal;
the battery cell 21 can be the battery cell 21 in any one of the embodiments as described above;
Step S02: obtaining a voltage difference between the first electrode terminal 211a and the third electrode 215;
as mentioned above, the first signal line 216a can be used to connect the first electrode terminal 211a with the third electrode 215, and the voltage difference between the first electrode terminal 211a and the third electrode 215 can be obtained through the first signal line 216a;
Step S03: determining a setting parameter of the battery cell 21 according to the voltage difference.

In the technical solution of the embodiments of the present application, by using the third electrode 215 as the reference electrode, the voltage difference between the first electrode terminal 211a and the third electrode 215 can be obtained, that is, the voltage difference between the negative electrode terminal and the third electrode 215 can be obtained. The setting parameter of the battery cell 21 can be determined according to the voltage difference, and the performance of the battery cell 21 can be determined.

The battery cell 21 further includes the casing 21a, the electrode assembly 213 is located within the casing 21a, and the casing 21a is multiplexed as the third electrode 215.

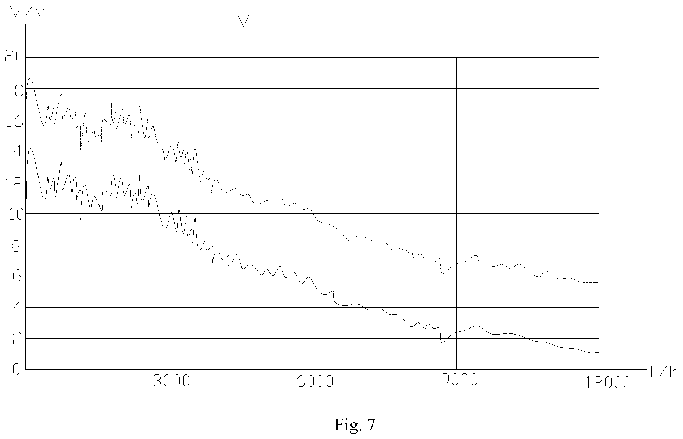

As shown in Fig. 7, Fig. 7 shows a time-variant curve line chart with the voltage differences between the first electrode terminal 211a and the third electrode 215 and between the second electrode terminal 211b and the third electrode 215 of the battery cell 21 that are not in a charging-and-discharging state according to an embodiment of the present application. Herein, a dashed line represents a curve line of the voltage difference between the second electrode terminal 211b and the third electrode 215, and a solid line represents a curve line of the voltage difference curve between the first electrode terminal 211a and the third electrode 215. As time goes by, when the casing 21a is corroded, the voltage difference between the first electrode terminal 211a and the third electrode 215 will gradually decrease.

According to some embodiments of the present application, in step S02, obtaining a first voltage difference between the casing 21a and the first electrode terminal 211a that are not in a charging-and-discharging state within a predetermined time period. In step S03, determining that corrosion of the casing 21a occurs when the first voltage difference decreases within the predetermined time period.

The duration of the predetermined time period can be set according to the actual situation.

In these optional embodiments, by multiplexing the casing 21a as the third electrode 215, the corrosion of the casing 21a can be determined according to the voltage difference between the third electrode 215 and the negative electrode terminal. If the casing 21a is not corroded, the voltage difference between the first electrode terminal 211a and the third electrode 215 should be constant when the battery cell 21 is not in the charging-and-discharging state. When the first voltage difference decreases, it indicates that there is electric charge transfer between the first electrode terminal 211a (i.e. the negative electrode terminal) and the casing 21a that are not in the charging-and-discharging state. Therefore, when the first voltage difference decreases, it can be determined that there is the corrosion of the casing 21a. The detecting method in the embodiments of the present application can not only indicate that the battery cell 21 has fault, but also determine that the fault type is the corrosion of the casing 21a, which can reduce the risk of the thermal runaway of the battery cell 21.

According to some embodiments of the present application, in the step of determining the setting parameter of the battery cell 21 according to the voltage difference: determining that the corrosion of the casing 21a is severe and sending an alarm signal when the first voltage difference is less than or equal to a first voltage threshold within the predetermined time period.

The first voltage threshold can be set according to the actual situation. For example, it can be determined in advance through experiments that the voltage difference between the negative electrode terminal and the third electrode 215 is the first voltage threshold when the severe corrosion of the casing 21a occurs.

In these optional embodiments, it can determine whether the corrosion of the casing 21a is severe by comparing the first voltage difference and the first voltage threshold. When the corrosion of the casing 21a is severe, the alarm signal is sent, so that it can facilitate the user to timely understand the condition of the corrosion of the casing 21a and improve the safety performance of the battery cell 21.

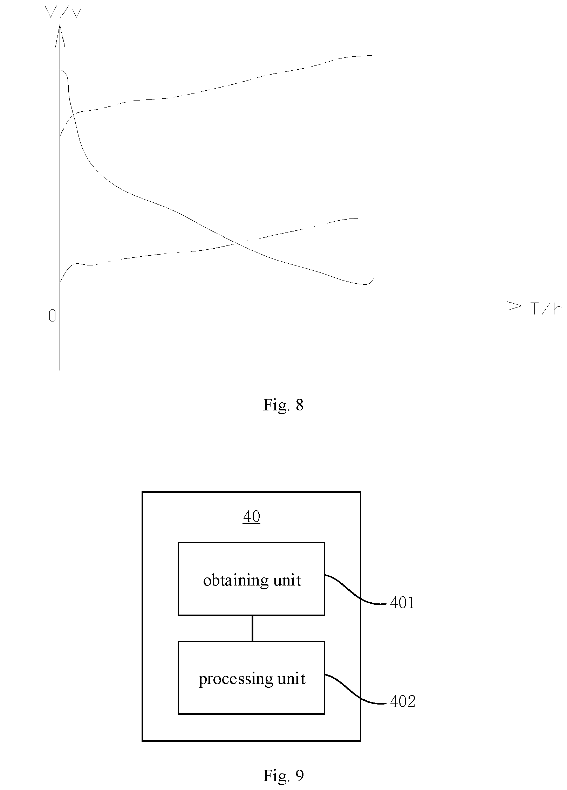

Referring to Fig. 4, Fig. 5, and Fig. 8 together. Fig. 8 shows a voltage difference curve line chart of the battery cell in a charging state. A dashed line represents a curve line of the voltage difference between the first electrode terminal 211a and the second electrode terminal 211b in the charging state, a dotted line represents an region of the voltage difference between the second electrode terminal 211b and the third electrode 215 in the charging state, and a solid line represents a region of the voltage difference between the first electrode terminal 211a and the third electrode 215 in the charging state. According to Fig. 8, it can be seen that the voltage difference between the third electrode 215 and the first electrode terminal 211a (i.e. the negative electrode terminal) steadily decreases during a charging phase.

According to some embodiments of the present application, in step S02: obtaining a second voltage difference between the first electrode terminal 211a and the third electrode 215 in the charging state; in step S03: determining that lithium precipitation of the first electrode terminal 211a occurs when the second voltage difference is less than or equal to a second voltage threshold.

The second voltage threshold can be set according to the actual situation. For example, it can be determined in advance through experiments that the voltage difference between the first electrode terminal 211a and the third electrode 215 is the second voltage threshold when the lithium precipitation of the first electrode terminal 211a occurs.

In these optional embodiments, by comparing the second voltage threshold with the second voltage difference in the charging state, it can be determined whether the lithium precipitation of the negative electrode terminal occurs. The detecting method in the embodiments of the present application can not only indicate that the battery cell 21 has fault, but also determine that the fault type is lithium precipitation of the negative electrode terminal, which can reduce the risk of the thermal runaway of the battery cell 21.

In addition, in the detecting method provided of the embodiments of the present application, the voltage differences between the first electrode terminal 211a and the third electrode 215 and between the second electrode terminal 211b and the third electrode 215 of the battery cell 21 of a formed product can be directly compared, and the fault situation of the battery cell 21 can be determined according to these voltage differences. The structure of the battery cell 21 of the formed product is closer to that of the battery cell 21 in actual use. Therefore, the result obtained through the detecting method provided by the embodiments of the present application can be more applicable to the actual product and can reduce the detecting deviation between the experimental data and the actual product.

Referring to Fig. 9, Fig. 9 shows a structural schematic view of a detecting module 40 of the battery cell according to an embodiment of the present application. The battery cell may be the battery cell 21 shown in Fig. 4 and Fig. 5.

According to some embodiments of the present application, as shown in Fig. 4, Fig. 5 and Fig. 9, the battery cell 21 includes the electrode assembly 213 and the third electrode 215, the electrode assembly 213 includes the first electrode terminal 211a and the second electrode terminal 211b, the first electrode terminal 211a is the negative electrode terminal, and the detecting module 40 includes an obtaining unit 401, configured to obtain the voltage difference between the first electrode terminal 211a and the third electrode 215; and a processing unit 402, configured to determine a setting parameter of the battery cell 21 according to the voltage difference.

The battery cell 21 may be the battery cell 21 in any one of the embodiments as described above. The battery cell 21 may include the first signal line 216a and the second signal line 216b. The first signal line 216a connects the first electrode terminal 211a with the third electrode 215, and the obtaining unit 401 can obtain the voltage difference between the first electrode terminal 211a and the third electrode 215 through the first signal line 216a.

In the technical solution in the embodiments of the present application, by using the third electrode 215 as the reference electrode, the obtaining unit 401 can obtain the voltage difference between the first electrode terminal 211a and the third electrode 215, that is, the voltage difference between the negative electrode terminal and the third electrode 215. The processing unit 402 can determine the setting parameter of the battery cell 21 and determine the performance of the battery cell 21 according to the voltage difference.

According to some embodiments of the present application, the battery cell 21 further includes the casing 21a, the electrode assembly 213 located in the casing 21a, and the casing 21a is multiplexed as the third electrode 215. The obtaining unit 401 is used to obtain the first voltage difference between the first electrode terminal 211a and the casing 21a of the battery cell 21 that are not in the charging-and-discharging state within a predetermined time period; the processing unit 402 is used to determine that corrosion of the casing 21a occurs when the first voltage difference decreases within the predetermined time period.

For example, the end cover 211 of the casing 21a is multiplexed as the third electrode 215. When the end cover 211 is multiplexed as the third electrode 215, the obtaining unit 401 can also obtain the first voltage difference between the first electrode terminal 211a and the end cover 211 of the battery cell 21 that are not in the charging-and-discharging state within the predetermined time period.

In the embodiments of the present application, by multiplexing the casing 21a as the third electrode 215, the processing unit 402 can determine the corrosion of the casing 21a according to the voltage difference between the third electrode 215 and the negative electrode terminal. When the first voltage difference decreases, it indicates that there is the electric charge transfer between the negative electrode terminal and the casing 21a that are not in the charging-and-discharging state, and corrosion of the casing 21a occurs. The detecting module 40 in the embodiments of the present application can not only indicate that the battery cell 21 has fault, but also determine that the fault type is the corrosion of the casing 21, which can reduce the risk of the thermal runaway of the battery cell 21.

According to some embodiments of the present application, the processing unit 402 is further configured to determine that the corrosion of the casing 21a is severe and send an alarm signal when the first voltage difference is less than or equal to a first voltage threshold. The setting manner of the first voltage threshold is described above and will not be repeated. The processing unit 402 can determine whether the corrosion of the casing 21a is severe by comparing the first voltage difference and the first voltage threshold. When the corrosion of the casing 21a is severe, the alarm signal is sent, so that it can facilitate the user to timely understand the condition of the corrosion of the casing 21a and improve the safety performance of the battery cell 21.

According to some embodiments of the present application, the obtaining unit 401 is further configured to obtain a second voltage difference between the first electrode terminal 211a and the third electrode 215 of the battery cell 21 in the charging state, and the processing unit 402 is further configured to determine that lithium precipitation of the first electrode terminal 211a occurs when the second voltage difference is less than or equal to a second voltage threshold.

A valuing manner of the second voltage threshold is described above and will not be repeated.

In the embodiment of the present application, the processing unit 402 can determine whether lithium precipitation of the negative electrode terminal occurs by comparing the second voltage threshold with the second voltage difference in the charging state. The detecting module 40 in the embodiments of the present application can not only indicate that the battery cell 21 has fault, but also determine that the fault type is lithium precipitation of the negative electrode terminal, which can reduce the risk of the thermal runaway of the battery cell 21.

According to some embodiments of the present application, as shown in Fig. 4 and Fig. 5, the battery cell 21 includes the casing 21a and a battery core assembly located in the casing 21a. The casing 21a includes the casing body 212 with the opening and the end cover 211 covering the opening. The battery core assembly includes the first electrode terminal 211a and the second electrode terminal 211b. The end cover 211 is multiplexed as the third electrode 215. The first signal line 216a is connected between the first electrode terminal 211a and the end cover 211 to obtain the voltage difference between the first electrode terminal 211a and the end cover 211. The second signal line 216b is connected between the second electrode terminal 211b and the end cover 211 to obtain the voltage difference between the second electrode terminal 211b and the end cover 211.

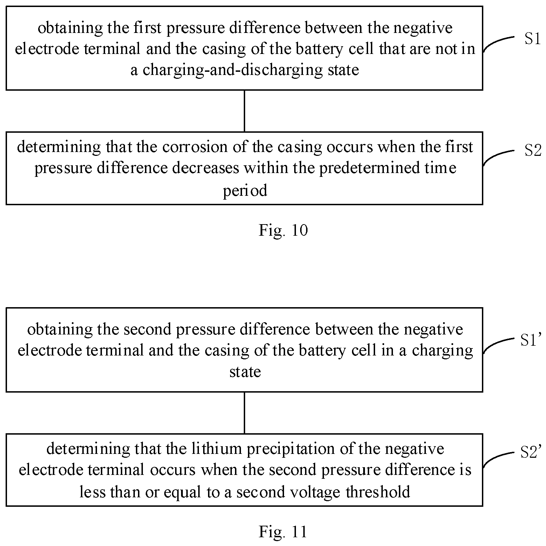

According to some embodiments of the present application, as shown in Fig. 10, the detecting method for the battery cell 21 shown in Fig. 4 and Fig. 5 includes:
Step S1: obtaining the first voltage difference between the casing 21a of the battery cell 21 and the negative electrode terminal that are not in a charging-and-discharging state within a predetermined time period;
Step S2: determining that corrosion of the casing 21a occurs when the first voltage difference decreases within the predetermined time period.

According to some embodiments of the present application, as shown in Fig. 11, the detecting method for the battery cell 21 includes:
Step S1': obtaining the second voltage difference between the negative electrode terminal and the casing 21a of the battery cell 21 in a charging state;
Step S2': determining that lithium precipitation of the negative electrode terminal occurs when the second voltage difference is less than or equal to a second voltage threshold.

At last, it should be noted that the above embodiments are only used to illustrate the technical solutions of the present application, but not to limit the technical solutions; although the present application has been described in detail with reference to the embodiments as described above, those skilled in the art should understand that: it is still possible to modify the technical solutions recited in the embodiments as described above, or equivalently replace some of the technical features, but these modifications or replacements do not cause the essence of the corresponding technical solutions to deviate from the scope of the technical solutions of the embodiments of the present application, and they should be covered within the scope of the claims and description of the present application. Especially, as long as there is no structural conflict, the various technical features mentioned in each embodiment can be combined in any way. The present application is not limited to the specific embodiments disclosed in the text, but includes all technical solutions falling within the scope of the claims.

## Claims

1. A battery cell (21), comprising:
a casing (21a), comprising a wall part (21aa) and an accommodating cavity (214) enclosed and formed by the wall part (21aa);
an electrode assembly (213), located in the accommodating cavity (214) and connected with a first electrode terminal (211a) and a second electrode terminal (211b);
a third electrode (215), arranged on the wall part (21aa); and
a signal line (216), comprising a first signal line (216a) connected with the third electrode (215) and the first electrode terminal (211a), and a second signal line (216b) connected with the third electrode (215) and the second electrode terminal (211b).

2. The battery cell (21) according to claim 1, wherein the casing (21a) comprises a conductive material and is multiplexed as the third electrode (215), the first signal line (216a) is connected with the casing (21a) and the first electrode terminal (211a), and the second signal line (216b) is connected with the casing (21a) and the second electrode terminal (211b).

3. The battery cell (21) according to claim 2, wherein the wall part (21aa) comprises a casing body (212) with an opening and an end cover (211) covering the opening, the end cover (211) is multiplexed as the third electrode (215), the first signal line (216a) is connected with the end cover (211) and the first electrode terminal (211a), and the second signal line (216b) is connected with the end cover (211) and the second electrode terminal (211b).

4. The battery cell (21) according to claim 1, wherein the wall part (21aa) comprises a casing body (212) with an opening and an end cover (211) covering the opening, and the third electrode (215) is located on a side of the end cover (211) away from the accommodating cavity (214).

5. A battery (10), comprising the battery cell (21) according to any one of claims 1 to 4.

6. An electricity-consuming apparatus, comprising the battery (10) according to claim 5, the battery (10) configured to supply electric power.

7. A detecting method for a battery cell (21), comprising:
providing a battery cell (21), comprising an electrode assembly (213) and a third electrode (215), the electrode assembly (213) comprising a first electrode terminal (211a) and a second electrode terminal (211b), and the first electrode terminal (211a) being a negative electrode terminal;
obtaining a voltage difference between the first electrode terminal (211a) and the third electrode (215); and
determining a setting parameter of the battery cell (21) according to the voltage difference.

8. The method according to claim 7, wherein the battery cell (21) further comprises a casing (21a), the electrode assembly (213) is located in the casing (21a), and the casing (21a) is multiplexed as the third electrode (215);
in the step of obtaining the voltage difference between the first electrode terminal (211a) and the third electrode (215): obtaining a first voltage difference between the first electrode terminal (211a) and the casing (21a) that are not in a charging-and-discharging state within a predetermined time period;
in the step of determining the setting parameter of the battery cell (21) according to the voltage difference: determining that corrosion of the casing (21a) occurs when the first voltage difference decreases within the predetermined time period.

9. The method according to claim 8, wherein in the step of determining the setting parameter of the battery cell (21) according to the voltage difference:
determining that the corrosion of the casing (21a) is severe and sending an alarm signal when the first voltage difference is less than or equal to a first voltage threshold within the predetermined time period.

10. The method according to any one of claims 7 to 9, wherein
in the step of obtaining the voltage difference between the first electrode terminal (211a) and the third electrode (215): obtaining a second voltage difference between the first electrode terminal (211a) and the third electrode (215) in a charging state;
in the step of determining the setting parameter of the battery cell (21) according to the voltage difference: determining that lithium precipitation of the first electrode terminal (211a) occurs when the second voltage difference is less than or equal to a second voltage threshold.

11. A detecting module (40) for a battery cell, wherein the battery cell (21) comprises an electrode assembly (213) and a third electrode (215), the electrode assembly (213) comprises a first electrode terminal (211a) and a second electrode terminal (211b), the first electrode terminal (211a) is a negative electrode terminal, and the detecting module (40) comprises:
an obtaining unit (401), configured to obtain a voltage difference between the first electrode terminal (211a) and the third electrode (215); and
a processing unit (402), configured to determine a setting parameter of the battery cell (21) according to the voltage difference.

12. The detecting module (40) according to claim 11, wherein the battery cell (21) further comprises a casing (21a), the electrode assembly (213) is located in the casing (21a), and the casing (21a) is multiplexed as the third electrode (215);
the obtaining unit (401) is configured to obtain a first voltage difference between the first electrode terminal (211a) and the casing (21a) of the battery cell (21) that are not in a charging-and-discharging state within a predetermined time period; and
the processing unit (402) is configured to determine that corrosion of the casing (21a) occurs when the first voltage difference decreases within the predetermined time period.

13. The detecting module (40) according to claim 12, wherein the processing unit (402) is further configured to determine that the corrosion of the casing (21a) is severe and send an alarm signal when the first voltage difference is less than or equal to a first voltage threshold.

14. The detecting module (40) according to any one of claims 11 to 13, wherein the obtaining unit (401) is further configured to obtain a second voltage difference between the first electrode terminal (211a) and the third electrode (215) of the battery cell (21) in a charging state, and the processing unit (402) is further configured to determine that lithium precipitation of the first electrode terminal (211a) occurs when the second voltage difference is less than or equal to a second voltage threshold.
